# EUROPÄISCHE PATENTSCHRIFT

(11) **EP 3 112 883 B1**
(45) Veröffentlichungstag und Bekanntmachung des Hinweises auf die Patenterteilung: **07.08.2019**
(21) Anmeldenummer: 16001451.0
(22) Anmeldetag: 29.06.2016
(51) Int. Cl.: G01R 15/18

(54) **MESSANORDNUNG UND VERFAHREN ZUR BERÜHRUNGSLOSEN STROMSTÄRKEMESSUNG**
MEASURING ASSEMBLY AND METHOD FOR CONTACTLESS CURRENT MEASUREMENT
DISPOSITIF DE MESURE ET PROCEDE DE MESURE DE L'INTENSITE DU COURANT SANS CONTACT

(30) Priorität: 30.06.2015 DE 102015008516
(43) Veröffentlichungstag der Anmeldung: 04.01.2017
(73) Patentinhaber: Testo AG, 79853 Lenzkirch (DE)
(72) Erfinder: Nesovic Nebojsa, 79211 Denzlingen (DE); Volger Jörg, 79211 Denzlingen (DE); Göpfert, Dirk, 79241 Ihringen (DE)
(74) Vertreter: Börjes-Pestalozza, Henrich

(56) Entgegenhaltungen:
- EP-A2- 2 589 971
- US-A- 5 057 769
- US-A1- 2003 112 000
- US-A1- 2010 207 603

## Beschreibung

Die Erfindung betrifft eine Messanordnung zur berührungslosen Messung von elektrischen Stromstärken mit einer Messspulenanordnung und einer Kompensationsspulenanordnung, wobei ein gemeinsames Signal der Messspulenanordnung und der Kompensationsspulenanordnung mit einer ersten Erfassungseinrichtung erfassbar ist.

Die Erfindung betrifft weiter ein Verfahren zur berührungslosen Stromstärkemessung in einem Stromleiter wobei in einer Messspulenanordnung ein Signal durch Induktion von dem Stromleiter erzeugt wird und der Messspulenanordnung eine Kompensationsspulenanordnung zugeordnet ist.

Es ist bekannt, berührungslose Stromstärkemessungen mit sogenannten Stromzangen durchzuführen, bei denen ein öffenbarer, ringförmiger Kern um einen Stromleiter gelegt und ein Magnetfeld des Stromleiters mit dem Kern eingefangen und induktiv gemessen wird. Der ringförmige Kern muss hierbei für jede Messung geöffnet und geschlossen werden, was aufwendig sein kann, wenn viele Stromleiter ausgemessen werden sollen und/oder wenn die Stromleiter schwer zugänglich sind.

Für eine Messung frei von Störungen durch extern, also außerhalb des Stromleiters, erzeugte Magnetfelder ist es günstig, wenn der Kern oder die Spule einen geschlossenen Ring um den Stromleiter beschreibt.

Es sind auch Spulenanordnungen bekannt, die hiervor abweichen und zur Kompensation von Störfeldern Kompensationsspulen aufweisen. Bei diesen Anordnungen wird ein gemeinsam in der Messspule und in einer zugehörigen Kompensationsspule induziertes Signal erfasst und ausgewertet.

Eine solche Spulenanordnung ist beispielsweise aus dem US Patent US 5,057,769 bekannt. Die hier gezeigte Anordnung weist eine im Wesentlichen C-förmige Messspule auf, an deren Enden jeweils eine Kompensationsspule angeordnet ist. Ein Problem bei dieser Anordnung ist jedoch, dass Fehlerzustände nicht immer zweifelsfrei feststellbar und zuordenbar sind, beispielsweise ob oder auf welcher Seite der zu messende Leiter außerhalb der Messspulen liegt.

Die US Patentanmeldung US 2010/0207603 A1 zeigt eine ähnliche Messanordnung, wobei hier jedoch nicht eine C-förmige Spule, sondern mehrere in einer C-Form angeordnete, miteinander verbundene Messspulen vorhanden sind. Zusätzlich zu den an den Enden der C-Form angeordneten Kompensatiönsspulen, ist hier auch in etwa der Mitte der Schenkel jeweils eine Kompensationsspule angeordnet. Hierdurch lassen sich Fehlerzustände besser erkennen und eingrenzen. Die Anordnung ist insgesamt jedoch recht aufwändig.

Aus der EP 2 589 971 A2 ist eine Strommesseinrichtung bekannt, bei der mehrere Messeinrichtungen im Wesentlichen um einen elektrischen Leiter herum angeordnet sind. Aus den Unterschieden des magnetischen Flusses in den einzelnen Messeinrichtungen kann eine genaue Lage des Leiters und der Stromstärke bestimmt werden. Die beschriebenen Anordnung weist weiterhin Mittel auf, um die Lage des Leiters zu einzustellen, so dass eine genaue Messung möglich ist. Eine solche Einstellung ist bei der erfindungsgemäßen Anwendung nicht möglich.

Der Erfindung liegt die Aufgabe zugrunde, die Gebrauchseigenschaften einer Messanordnung zur berührungslosen Stromstärkemessung zu verbessern.

Zur Lösung der genannten Aufgabe sind erfindungsgemäß die Merkmale von Anspruch 1 vorgesehen. Insbesondere wird somit bei einer Messanordnung der eingangs beschriebenen Art erfindungsgemäß vorgeschlagen, dass ein Signal wenigstens einer Messspule der Messspulenanordnung mit einer zweiten Erfassungseinrichtung erfassbar ist. Von Vorteil ist dabei, dass eine zweite Messgröße zusätzlich zu der physikalisch mit Kompensationsspulen kompensierten Messgröße bereitstellbar ist. Mit dieser zweiten Messgröße ist ein Messergebnis für die erste Messgröße nochmals verbesserbar. Mit der zweiten Messgröße ist alternativ oder zusätzlich eine Plausibilitätsprüfung der Messsituation durchführbar, indem beispielsweise die zweite (unkompensierte) Messgröße mit der ersten (kompensierten) Messgröße vergleichbar ist und verglichen wird. Die Erfindung ermöglicht somit die Verbesserung der Messgenauigkeit bei einer gabelförmigen, starren Messanordnung. Dies verbessert die Gebrauchseigenschaften, da ein Öffnen und Schließen eines ringförmigen Kerns zur Messung verzichtbar ist.

Bei einer vorteilhaften Ausgestaltung kann vorgesehen sein, dass die Messspulenanordnung eine erste Messspule und eine zweite Messspule aufweist. Somit ist eine Alternative zu einer einzigen, beispielweise U-förmigen Messspule bereitstellbar. Insbesondere kann hierbei vorgesehen sein, dass die erste Messspule und die zweite Messspule auf einander gegenüber liegenden Seiten oder beidseits einer Stromleiteraufnahme angeordnet sind. Von Vorteil ist dabei, dass ein magnetisches Feld des Stromleiters beidseits des Stromleiters erfassbar ist.

Bei einer vorteilhaften Ausgestaltung kann vorgesehen sein, dass einer, insbesondere jeder, Messspule der Messspulenanordnung wenigstens eine Kompensationsspule der Kompensationsspulenanordnung elektrisch zugeordnet ist/sind. Die elektrische Zuordnung kann beispielsweise ermöglichen, dass sich eine in der Messspule induzierte Spannung und eine in der wenigstens einen Kompensationsspule induzierte Spannung vorzeichenrichtig addieren und so externe Störeinflüsse eliminiert werden. Somit ist eine Kompensation von externen Störfeldern einfach physikalisch erreichbar. Vorzugsweise ist/sind der oder jeder Messspule zwei Kompensationsspulen elektrisch zugeordnet. Die Verwendung von zwei Kompensationsspulen pro Messspule ermöglicht eine nochmals gesteigerte Unterdrückung von externen Störfeldern, beispielsweise eines benachbart liegenden, nicht zu messenden Stromleiters.

Bei einer vorteilhaften Ausgestaltung kann vorgesehen sein, dass die einer Messspule zugeordneten Kompensationsspulen an je einem Ende der Messspule angeordnet sind. Hierdurch ist eine besonders gute Approximation einer ringförmig den Stromleiter umschließenden Messspule erreichbar.

Hierbei oder alternativ kann vorgesehen sein, dass die einer Messspule zugeordneten Kompensationsspulen in einem Winkel zwischen 45° und 135° zu der Messspule ausgerichtet sind. Von Vorteil ist dabei, dass in den Kompensationsspulen automatisch eine Spannung induziert wird, welche für einen außerhalb einer von der Messspulenanordnung beschriebenen oder definierten Stromleiteraufnahme liegenden Stromleiter eine in der Messspule induzierte Spannung kompensiert. Dieser Effekt wird umso besser erreichbar, je mehr sich der Winkel an 90° annähert. Bevorzugt liegt der Winkel daher zwischen 80° und 100°. Besonders bevorzugt beträgt der Winkel daher ungefähr, beispielsweise im Rahmen einer Fertigungsgenauigkeit oder Fertigungstoleranz, oder sogar genau 90°.

Bei einer vorteilhaften Ausgestaltung kann vorgesehen sein, dass die erste Erfassungseinrichtung und die zweite Erfassungseinrichtung jeweils ein Verstärkungsglied aufweisen. Von Vorteil ist dabei, dass unabhängig voneinander gewonnene Signale bereitstellbar und weiter verarbeitbar sind.

Bei einer vorteilhaften Ausgestaltung kann vorgesehen sein, dass an die erste Erfassungseinrichtung und die zweite Erfassungseinrichtung jeweils eine digitale Signalverarbeitungseinrichtung angeschlossen ist. Von Vorteil ist dabei, dass eine Weiterverarbeitung mittels Schneller Fouriertransformation (Fast Fourier Transform, FFT) durchführbar ist. Dies ermöglicht eine einfache Filterung und Einstellung auf eine Frequenz einer zu messenden Stromstärke.

Bei einer vorteilhaften Ausgestaltung kann vorgesehen sein, dass mit der zweiten Erfassungseinrichtung ein Signal einer, beispielsweise der bereits erwähnten, ersten Messspule der Messspulenanordnung erfassbar ist, und mit einer dritten Erfassungseinrichtung ein Signal einer, beispielsweise der bereits erwähnten, zweiten Messspule der Messspulenanordnung erfassbar ist. Somit ist unterscheidbar, ob ein externer Stromleiter auf der Seite der ersten Messspule oder der zweiten Messspule angeordnet ist.

Bei einer vorteilhaften Ausgestaltung kann vorgesehen sein, dass die Kompensationsspulen der Kompensationsspulenanordnung im Wesentlichen, beispielsweise bis auf Fertigungstoleranzen oder für eine angestrebte Messgenauigkeit zu vernachlässigende Unterschiede, identische oder sogar genau identische Querschnitte, Wicklungsdichten und/oder Windungszahlen aufweisen. Von Vorteil ist dabei, dass die Auslegung der Spulen zur Kompensation der externen Störfelder einfach ermittelbar und realisierbar ist. Beispielsweise können die tolerierten Abweichungen kleiner als 10% des jeweiligen Nominalwerts, insbesondere kleiner als 5% des jeweiligen Nominalwerts, betragen.

Bei einer vorteilhaften Ausgestaltung kann vorgesehen sein, dass die Messspulen der Messspulenanordnung im Wesentlichen identische, beispielsweise bis auf Fertigungstoleranzen oder für eine angestrebte Messgenauigkeit zu vernachlässigende Unterschiede, oder sogar genau identische Querschnitte, Wicklungsdichten und/oder Windungszahlen aufweisen. Von Vorteil ist dabei, dass die Messspulen aufeinander abgestimmt und einfach kompensierbar sind. Beispielsweise können die tolerierten Abweichungen kleiner als 10% des jeweiligen Nominalwerts, insbesondere kleiner als 5% des jeweiligen Nominalwerts, betragen.

Bei einer vorteilhaften Ausgestaltung kann vorgesehen sein, dass eine Windungszahl wenigstens einer Messspule der Messspulenanordnung größer als eine Windungszahl wenigstens einer zugehörigen Kompensationsspule der Kompensationsspulenanordnung ist. Somit ist in der Messspule das eigentliche Messsignal erzeugbar, welches durch die induzierte Spannung der Kompensationsspulen gegebenenfalls kompensiert wird. Bevorzugt ist die Windungszahl jeder Messspule im Wesentlichen, beispielsweise im Rahmen der Messgenauigkeit der Stromstärkemessung, oder sogar genau gleich der Summe der Windungszahlen der zugeordneten Kompensationsspulen.

Bei einer vorteilhaften Ausgestaltung kann vorgesehen sein, dass die Messspulen und die Kompensationsspulen in einer an die erste Erfassungseinrichtung angeschlossenen Masche angeordnet sind. Von Vorteil ist dabei, dass die induzierten Spannungen der Messspulen und der Kompensationsspulen physikalisch addiert werden, bevor das kompensierte Signal von der ersten Erfassungseinrichtung erfasst wird.

Bei einer vorteilhaften Ausgestaltung kann vorgesehen sein, dass die Wicklungsrichtungen der Messspulen und der Kompensationsspulen übereinstimmen. Somit ist eine physikalische Kompensation der induzierten Spannungen von externen Stromleitern einfach erreichbar.

Bei einer vorteilhaften Ausgestaltung kann vorgesehen sein, dass die Messspulen und/oder die Kompensationsspulen als Luftspulen ausgebildet sind. Somit ist der Einsatz von Kernmaterial verzichtbar.

Bei einer vorteilhaften Ausgestaltung kann vorgesehen sein, dass die Messspulenanordnung und/oder die Kompensationsspulenanordnung eine, beispielsweise die bereits erwähnte, Stromleiteraufnahme für einen zu messenden Stromleiter definieren. Von Vorteil ist dabei, dass die Messspulenanordnung somit einen empfindlichen Bereich definiert, in welchem eine Stromstärke eines Stromleiters messbar ist, während außerhalb der Stromleiteraufnahme angeordnete Stromleiter unterdrückt werden. Insbesondere kann hierbei vorgesehen sein, dass die Stromleiteraufnahme zwischen einer, beispielsweise der bereits erwähnten, ersten Messspule der Messspulenanordnung und einer, beispielsweise der bereits erwähnten, zweiten Messspule der Messspulenanordnung definiert und ausgebildet ist. Somit ist eine symmetrische oder die Stromleiteraufnahme nach außen begrenzende Anordnung der Messspulen bereitgestellt.

Besonders günstig ist es hierbei, wenn die Stromleiteraufnahme gabelförmig und/oder starr, insbesondere ohne bewegliche Teile, ausgebildet ist. Somit ist eine besonders einfach handhabbare und/oder mechanisch robuste Messanordnung bereitstellbar.

Bei einer vorteilhaften Ausgestaltung kann vorgesehen sein, dass die Messspulenanordnung und/oder die Kompensationsspulenanordnung jeweils räumlich spiegelsymmetrisch angeordnet sind. Somit ist eine einfache Anordnung bereitgestellt, für welche eine nahezu vollständige Kompensation externer Einflüsse auf eine Messung besonders einfach erreichbar ist. Bevorzugt ist eine Spiegelebene der Spiegelsymmetrie mittig in Bezug auf eine, beispielsweise die bereits erwähnte, Stromleiteraufnahme angeordnet.

Bei einer vorteilhaften Ausgestaltung kann vorgesehen sein, dass die Messspulenanordnung und die Kompensationsspulenanordnung so abgestimmt sind, dass die Summe der magnetischen Flüsse in den Messspulen und den Kompensationsspulen für einen außerhalb einer oder der Stromleiteraufnahme liegenden Stromleiter gleich Null ist. Somit ist ein Einfluss eines externen Stromleiters auf eine Stromstärkemessung praktisch eliminierbar.

Bei einer vorteilhaften Ausgestaltung kann vorgesehen sein, dass eine Messfehlererkennungseinrichtung zum Vergleich der Signale der ersten Messspule und/oder zweiten Messspule einerseits mit dem gemeinsamen Signal der Messspulenanordnung und der Kompensationsspulenanordnung andererseits eingerichtet ist. Somit ist eine Plausibilitätsprüfung einfach durchführbar, da nur ein externer Stromleiter ein unkompensiertes Signal in der Messspule erzeugt, welches größer als das kompensierte Signal ist. Es ist somit leicht erkennbar, dass ein Messfehler vorliegt, wenn der (einzige) zu messende Stromleiter außerhalb der Stromleiteraufnahme liegt. Insbesondere kann hierbei vorgesehen sein, dass die Messfehlererkennungseinrichtung zu einer Ausgabe eines Messfehlerhinweises, wenn das gemeinsame Signal kleiner als das Signal der ersten Messspule und/oder der zweiten Messspule ist, eingerichtet ist. Dies ermöglicht dem Anwender, Messfehler einfach zu erkennen und beispielsweise durch Widerholungsmessungen zu vermeiden.

Bei einer vorteilhaften Ausgestaltung kann vorgesehen sein, dass eine Aktivierungsvorrichtung zu einer Erfassung eines Signals der Messspulenanordnung und/oder der Kompensationsspulenanordnung und zu einer Aktivierung einer weiteren Komponente zur Verarbeitung und/oder Ausgabe eines Messwerts der Messspulenanordnung, wenn das Signal ein hinterlegtes Kriterium erfüllt, eingerichtet ist. Somit sind zusätzliche Bedienschritte zur Aktivierung der Messanordnung verzichtbar. Dies kann beispielsweise durch Polling eingerichtet sein, also durch eine regelmäßige Abfrage, ob die erfindungsgemäß bereitgestellten und/oder gew0onnenen Signale der Messspulenanordnung auf einen eingelegten Stromleiter deuten. Das hinterlegte Kriterium kann beispielsweise ein Überschreiten eines Schwellwertes für eine Spannung in der Messspule und/oder ein Ergebnis eines Vergleich des gemeinsamen Signals der Messspulenanordnung und der Kompensationsspulenanordnung mit dem Signal der wenigstens einen Messspule sein. Beispielsweise kann eine Aktivierung erfolgen, wenn die Spannung in der Messspulenanordnung oder die kompensierte Spannung einen Schwellwert überschreitet und die Spannung in der Messspulenanordnung außerdem nicht größer als die kompensierte Spannung ist.

Bei einer vorteilhaften Ausgestaltung kann vorgesehen sein, dass eine Messbereichsumschalteinrichtung zu einem Umschalten von einer Verarbeitung des gemeinsamen Signals der Messspulenanordnung und der Kompensationsspulenanordnung zu einer Verarbeitung des Signals der Messspulenanordnung allein, wenn das Signal einen Schwellwert übersteigt, eingerichtet ist. Von Vorteil ist dabei, dass die Messspule(n) ohne Kompensation für große Stromstärken und die kompensierten Messspulen für kleine Stromstärken, bei denen externe Störfelder einen größeren relativen Fehler verursachen können, nutzbar sind, wobei zusätzliche Bedienschritte beispielsweise zur Messbereichsumschaltung verzichtbar sind.

Zur Lösung der genannten Aufgabe sind bei einem Verfahren die Merkmale des auf ein Verfahren gerichteten, nebengeordneten Anspruchs vorgesehen. Insbesondere wird somit bei einem Verfahren der eingangs beschriebenen Art erfindungsgemäß zur Lösung der Aufgabe vorgeschlagen, dass ein gemeinsames Signal der Messspulenanordnung und der Kompensationsspulenanordnung erfasst wird und dass zusätzlich ein Signal wenigstens einer Messspule der Messspulenanordnung erfasst wird. Somit ist ein zweites, unabhängiges Signal gewonnen, welches eine Beurteilung der Messsituation, eine Aktivierung einer Messung und/oder eine verbesserte Genauigkeit der Messung ermöglicht. Hierdurch ergeben sich jeweils verbesserte Gebrauchseigenschaften bei der Stromstärkemessung.

Bei einer vorteilhaften Ausgestaltung kann vorgesehen sein, dass ein Messfehlerhinweis, wenn das gemeinsame Signal kleiner als das Signal der wenigstens einen Messspule ist, ausgegeben wird. Von Vorteil ist dabei, dass eine Messung eines externen Stromleiters von einer Messung eines in eine Stromleiteraufnahme eingelegten Stromleiters einfach unterschieden wird.

Bei einer vorteilhaften Ausgestaltung kann vorgesehen sein, dass von einer Auswertung des gemeinsamen Signals auf eine Auswertung des Signals der wenigstens einen Messspule, wenn das Signal einen Schwellwert überschreitet, umgeschaltet wird. Von Vorteil ist dabei, dass eine automatische Messbereichsumschaltung ausgeführt wird. Zusätzliche Bedienschritte durch einen Anwender sind verzichtbar.

Bei einer vorteilhaften Ausgestaltung kann vorgesehen sein, dass eine erfindungsgemäße Messanordnung, insbesondere wie zuvor beschrieben und/oder nach einem der auf eine Messanordnung gerichteten Ansprüche, verwendet wird.

Die Erfindung wird nun anhand eines Ausführungsbeispiels näher beschrieben, ist aber nicht auf dieses Ausführungsbeispiel beschränkt. Weitere Ausführungsbeispiele ergeben sich durch Kombination der Merkmale einzelner oder mehrerer Ansprüche untereinander und/oder mit einzelnen oder mehreren Merkmalen des Ausführungsbeispiels.

Es zeigt in stark vereinfachter Darstellung
- Fig. 1: einen Ausschnitte einer erfindungsgemäßen Messanordnung und
- Fig. 2: eine erfindungsgemäße Verschaltung der Messanordnung nach Fig. 1.

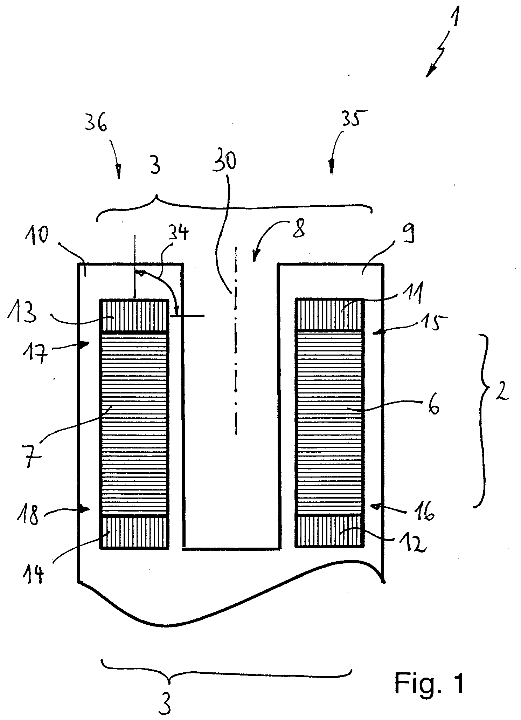

Figur 1 zeigt in stark vereinfachter Darstellung den vorderen Teil einer im Ganzen mit 1 bezeichneten erfindungsgemäßen Messanordnung zur berührungslosen Messung von elektrischen Stromstärken.

Zur Vereinfachung der Darstellung ist der Griff der Messanordnung 1, der die Auswerteelektronik, Mittel zur Ausgabe von Messwerten, beispielsweise über ein Display, und Bedienelemente aufweist, nicht weiter dargestellt.

Die erfindungsgemäße Messanordnung 1 hat eine Messspulenanordnung 2 und eine Kompensationsspulenanordnung 3.

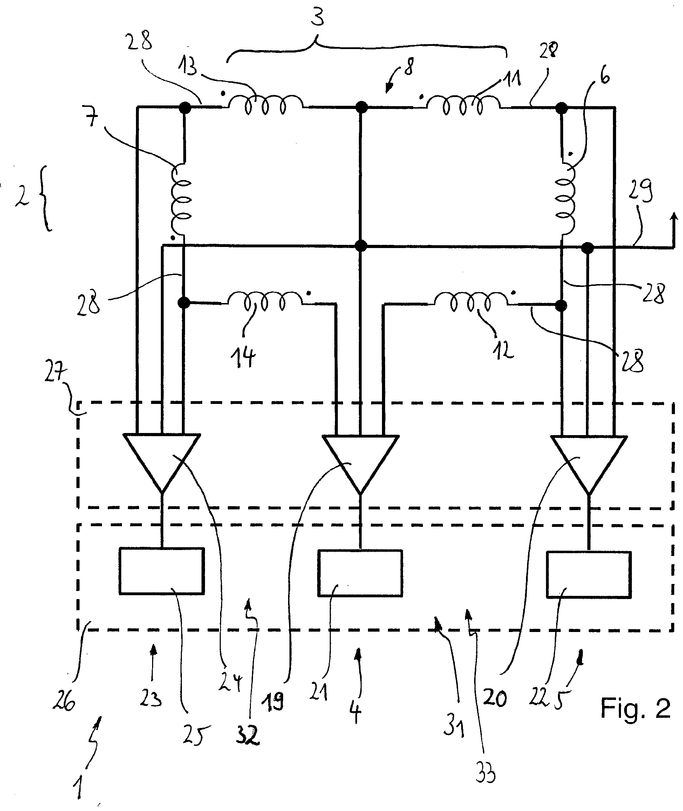

Figur 2 zeigt die zugehörige Verschaltung.

Die Messanordnung 1 hat demnach eine erste Erfassungseinrichtung 4, mit welcher ein Signal der Messspulenanordnung 2 und der Kompensationsspulenanordnung 3 erfassbar ist.

Die Messanordnung 1 hat weiter eine zweite Erfassungseinrichtung 5, mit welcher ein Signal einer ersten Messspule 6 der Messspulenanordnung 2 getrennt von der Kompensationsspulenanordnung 3 erfassbar ist.

Die Messspulenanordnung 2 hat eine zweite Messspule 7. Die erste Messspule 6 und die zweite Messspule 7 sind beidseits auf einander gegenüberliegenden Seiten 35, 36 einer gabelförmigen Stromleiteraufnahme 8 angeordnet.

In die Stromleiteraufnahme 8 ist der zu messende Stromleiter einlegbar.

Die Stromleiteraufnahme 8 ist starr ohne bewegliche Teile ausgebildet.

Die Messspulen 6, 7 sind somit in je einer Gabelzinke 9, 10 angeordnet.

Die Kompensationsspulenanordnung 3 weist vier Kompensationsspulen 11, 12, 13, 14 auf.

In Figur 2 ist ersichtlich, dass die Kompensationsspulen 11, 12 der ersten Messspule 6 elektrisch zugeordnet sind, während die Kompensationsspulen 13, 14 der zweiten Messspule 7 elektrisch zugeordnet sind.

In der Darstellung gemäß Figur 1 ist ersichtlich, dass an jeder Messspule 6, 7 an den Enden 15, 16, 17, 18 jeweils eine Kompensationsspule 11, 12, 13, 14 angeordnet ist.

Jede der Kompensationsspulen 11, 12, 13, 14 ist hierbei in einem Winkel 34 von 90° zu der jeweils zugehörigen Messspule 6, 7 ausgerichtet.

Die erste Erfassungseinrichtung 4 weist ein Verstärkungsglied 19 und eine nachgeschaltete digitale Signalverarbeitungseinrichtung 21 auf.

Die zweite Erfassungseinrichtung 5 hat gleichermaßen ein Verstärkungsglied 20 und eine nachgeschaltete digitale Signalverarbeitungseinrichtung 22.

Die Messanordnung 1 hat weiter eine dritte Erfassungseinrichtung 23, mit welcher ein Signal der zweiten Messspule 7 der Messspulenanordnung 2 getrennt von der Kompensationsspulenanordnung 3 und der ersten Messspule 6 erfassbar ist.

Die dritte Erfassungseinrichtung 23 hat in analoger Weise ein Verstärkungsglied 24 und eine digitale Signalverarbeitungseinrichtung 25.

Die digitalen Signalverarbeitungseinrichtungen 21, 22, 25 sind Bestandteil einer digitalen Signalverarbeitung 26, während die Verstärkungsglieder 19, 20, 24 Teil einer Signalverstärkung 27 sind.

Die Kompensationsspulen 11, 12, 13, 14 sind zueinander identisch ausgebildet und weisen daher übereinstimmende Querschnitte, Wicklungsdichten und Windungszahlen auf.

Die Messspulen 6, 7 sind zueinander identisch ausgebildet und weisen daher übereinstimmende Querschnitte, Wicklungsdichten und Windungszahlen auf.

Die Windungszahlen der Messspulen 6, 7 sind jeweils größer als die Windungszahlen der Kompensationsspulen 11, 12, 13, 14.

Hierbei ist die Summe der Windungszahlen der Kompensationsspulen 11, 12, 13, 14 einer Messspule 6, 7 gleich der Windungszahl der jeweils zugehörigen Messspule 6, 7.

Die Messspulen 6, 7 und die Kompensationsspulen 11, 12, 13, 14 sind in einer gemeinsamen Masche 28 angeordnet und an die erste Erfassungseinrichtung 4 angeschlossen. Es ist in Figur 2 ersichtlich, dass die Messspule 6 und die zugehörigen Kompensationsspulen 11, 12 übereinstimmende Wicklungsrichtungen: aufweisen. Ebenso weisen die Messspule 7 und die zugehörigen Kompensationsspulen 13, 14 übereinstimmende Wicklungsrichtungen auf.

Die Verstärkungsglieder 19, 20, 24 sind außerdem an eine Versorgungsspannung 29 angeschlossen.

Die Messspulen 6, 7 und die Kompensationsspulen 11, 12, 13, 14 sind jeweils ohne Kern als Luftspulen ausgebildet.

Aus Figur 1 ersichtlich, dass die Messspulen 6, 7 zwischen sich die Stromleiteraufnahme 8 definieren, wobei die Anordnung der Messspulen 6, 7 und die Anordnung der Kompensationsspulen 11, 12, 13, 14 bezüglich einer Mittelebene 30 der Stromleiteraufnahme 8 räumlich spiegelsymmetrisch ausgebildet sind.

Die Kompensationsspulenanordnung 3 ist auf die Messspulenanordnung 2 derart abgestimmt, dass die Summe der magnetischen Flüsse in den Messspulen 6, 7 und den Kompensationsspulen 11, 12, 13, 14 für einen außerhalb der Stromleiteraufnahme 8 liegenden Stromleiter gleich Null ist. Somit werden magnetische Felder, die von einem Stromleiter außerhalb der Stromleiteraufnahme 8 erzeugt werden, gerade so kompensiert, dass in der ersten Erfassungseinrichtung 4 kein Messsignal erzeugt wird.

In der digitalen Signalverarbeitung 26 ist eine Messfehlererkennungseinrichtung 31 ausgebildet, mit welcher die Signale der ersten Messspule 6 und der zweiten Messspule 7 jeweils für sich genommen einerseits und das gemeinsame Signal der Messspulenanordnung 2 und der Kompensationsspulenanordnung 3 andererseits, also die Signale an den Verstärkungsgliedern 20, 24 einerseits und an den Verstärkungsglied 19 andererseits, miteinander vergleichbar sind. Die Messfehlererkennungseinrichtung 31 ist so eingerichtet, dass für den Fall, dass das gemeinsame Signal kleiner als das Signal der ersten Messspule 6 oder kleiner als das Signal der zweiten Messspule 7 ist, ein Messfehlerhinweis ausgegeben wird. Dieses Größenverhältnis deutet darauf hin, dass der Stromleiter nicht in der Stromleiteraufnahme 8, sondern außerhalb der Stromleiteraufnahme 8 liegt. Der Messfehlerhinweis zeigt daher an, dass möglicherweise der falsche oder gar kein Stromleiter in der Stromleiteraufnahme 8 erfasst ist.

Die digitale Signalverarbeitung 26 weist weiter eine Aktivierungsvorrichtung 32 auf, mit welcher wenigstens ein Signal der Messspulenanordnung 2 und der Kompensationsspulenanordnung 3 erfassbar ist.

Wenn die erfassten Signale ein Kriterium erfüllen, nach welchem das Signal an der ersten Messspule 6 und/oder der zweiten Messspule 7 einen hinterlegten Schwellwert überschreitet/überschreiten und gleichzeitig dieses Signal nicht größer als die kompensierte Spannung an der ersten Erfassungseinrichtung 4 ist, wird eine weitere Komponente zur Verarbeitung und/oder Ausgabe eines Messwerts der Messspulenanordnung aktiviert. Hierdurch wird der Normalbetrieb der Messanordnung 1 eingeschaltet.

In der digitalen Signalverarbeitung 26 ist weiter eine Messbereichsumschalteinrichtung 33 ausgebildet.

Diese Messbereichsumschalteinrichtung 33 ist zu einem Umschalten von einer Verarbeitung des gemeinsamen Signals an der ersten Erfassungseinrichtung 4 zu einer Verarbeitung des Signals an der zweiten Erfassungseinrichtung 5 und/oder der dritten Erfassungseinrichtung 23 eingerichtet. Dies erfolgt, wenn das Signal stark genug ist, um eine Stromstärkemessung nur mit den Messspulen 6, 7 ohne Kompensation ausführen zu können.

Mit der Messanordnung 1 ist somit ein Verfahren zu berührungslosen Stromstärkemessung in einem stromdurchflossenen Leiter ausführbar, wobei der Leiter in die Stromleiteraufnahme 8 eingelegt wird.

Mit der Messspulenanordnung 2 wird somit ein elektrisches Signal durch Induktion erzeugt.

Zusätzlich wird in der Kompensationsspulenanordnung 3 ebenfalls ein elektrisches Signal induktiv erzeugt, wobei dieses Signal das Signal der Messspulenanordnung 2 zumindest teilweise kompensiert.

In der ersten Erfassungseinrichtung 4 wird das gemeinsame Signal der Messspulenanordnung 2 und der Kompensationsspulenanordnung 3, also das kompensierte Signal erfasst, und in der zweiten Erfassungseinrichtung 5 und der dritten Erfassungseinrichtung 23 wird jeweils zusätzlich ein Signal der Messspule 6 beziehungsweise der Messspule 7 jeweils für sich genommen erfasst.

Sofern das Signal der Messspule 6 oder das Signal der Messspule 7 größer als das gemeinsame Signal an der ersten Erfassungseinrichtung 4 ist, wird ein Messfehlerhinweis ausgegeben, da dann der ausgemessene Stromleiter außerhalb der Stromleiteraufnahme 8 liegen muss.

Sofern das Signal an einer der Erfassungseinrichtung 4, 5, 23 einen Schwellwert überschreitet, wird von einer Auswertung des gemeinsamen Signals zur Gewinnung des Messwerts auf einer Auswertung der Einzelsignale der Messspule 6, 7 umgeschaltet.

Hierbei wird benutzt, dass die Verstärkungsglieder 20, 24 auf einen anderen Messwertbereich eingestellt sind als das Verstärkungsglied 19, bei welchem ein kompensiertes Signal anliegt.

Durch diese Messbereichsumschaltung ist somit die kompensierte Ausmessung: eines eingelegten Stromleiters mit geringer Stromstärke ebenso durchführbar wie die unkompensierte Messung eines Stromleiters mit großer Stromstärke.

Bei der Messanordnung 1 zur berührungslosen Messung von elektrischen Stromstärken wird vorgeschlagen, ein gemeinsames Signal einer Messspulenanordnung 2 und einer Kompensationsspulenanordnung 3 mit einer ersten Erfassungseinrichtung 4 zu erfassen und ein Signal wenigstens einer Messspule 6, 7 der Messspulenanordnung 2 separat hiervon mit einer zweiten Erfassungseinrichtung 5, 23 zu erfassen.

### Bezugszeichenliste

- 1: Messanordnung
- 2: Messspulenanordnung
- 3: Kompensationsspulenanordnung
- 4: erste Erfassungseinrichtung
- 5: zweite Erfassungseinrichtung
- 6: erste Messspule
- 7: zweite Messspule
- 8: Stromleiteraufnahme
- 9: Gabelzinke
- 10: Gabelzinke
- 11: Kompensationsspule
- 12: Kompensationsspule
- 13: Kompensationsspule
- 14: Kompensationsspule
- 15: Ende von 6
- 16: Ende von 6
- 17: Ende von 7
- 18: Ende von 7
- 19: Verstärkungsglied
- 20: Verstärkungsglied
- 21: digitale Signalverarbeitungseinrichtung
- 22: digitale Signalverarbeitungseinrichtung
- 23: dritte Erfassungseinrichtung
- 24: Verstärkungsglied
- 25: digitale Signalverarbeitungseinrichtung
- 26: digitale Signalverarbeitung
- 27: Signalverstärkung
- 28: Masche
- 29: Versorgungsanschluss
- 30: Mittelebene
- 31: Messfehlererkennungseinrichtung
- 32: Aktivierungseinrichtung
- 33: Messbereichsumschalteinrichtung
- 34: Winkel
- 35: Seite von 8
- 36: Seite von 8

## Patentansprüche

1. Messanordnung (1) zur berührungslosen Messung von elektrischen Stromstärken, mit einer Messspulenanordnung (2), einer Kompensationsspulenanordnung (3) und einer ersten Erfassungseinrichtung (4), welche eingerichtet ist, ein gemeinsames Signal der Messspulenanordnung (2) und der Kompensationsspulenanordnung (3) zu erfassen **gekennzeichnet durch** eine zweite Erfassungseinrichtung (5), die eingerichtet ist, zusätzlich ein Signal wenigstens einer Messspule (6, 7) der Messspulenanordnung (2) zu erfassen.

2. Messanordnung (1) nach Anspruch 1, **dadurch gekennzeichnet, dass** die Messspulenanordnung (2) eine erste Messspule (6) und eine zweite Messspule (7) aufweist, insbesondere beidseits und/oder auf einander gegenüber liegenden Seiten (35, 36) einer Stromleiteraufnahme (8), und/oder dass einer oder jeder Messspule (6, 7) der Messspulenanordnung (2) wenigstens eine Kompensationsspule (11, 12, 13, 14), vorzugsweise zwei Kompensationsspulen (11, 12, 13, 14), der Kompensationsspulenanordnung (3) elektrisch zugeordnet ist/sind.

3. Messanordnung (1) nach Anspruch 1 oder 2, **dadurch gekennzeichnet, dass** die einer Messspule (6, 7) zugeordneten Kompensationsspulen (11, 12, 13, 14) an je einem Ende (15, 16, 17, 18) der Messspule (6, 7) angeordnet und/oder in einem Winkel zwischen 45° und 135°, bevorzugt zwischen 80° und 100°, besonders bevorzugt von 90°, zu der Messspule (6, 7) ausgerichtet sind.

4. Messanordnung (1) nach einem der Ansprüche 1 bis 3, **dadurch gekennzeichnet, dass** die erste Erfassungseinrichtung (4) und die zweite Erfassungseinrichtung (5) jeweils ein Verstärkungsglied (19, 20) aufweisen und/oder dass an die erste Erfassungseinrichtung (4) und die zweite Erfassungseinrichtung (5) jeweils eine digitale Signalverarbeitungseinrichtung (19, 20) angeschlossen ist.

5. Messanordnung (1) nach einem der Anspruche 1 bis 4, **dadurch gekennzeichnet, dass** die zweite Erfassungseinrichtung (5) eingerichtet ist, ein Signal einer oder der ersten Messspule (6) der Messspulenanordnung (2) zu erfassen, und eine dritte Erfassungseinrichtung (23) eingerichtet ist, ein Signal einer oder der zweiten Messspule (7) der Messspulenanordnung (2) zu erfassen.

6. Messanordnung (1) nach einem der Ansprüche 1 bis 5, **dadurch gekennzeichnet, dass** die Kompensationsspulen (11, 12, 13, 14) der Kompensationsspulenanordnung (3) im Wesentlichen identische Querschnitte, Wicklungsdichten und/oder Windungszahlen aufweisen und/oder dass die Messspulen (6, 7) der Messspulenanordnung (2) im Wesentlichen identische Querschnitte, Wicklungsdichten und/oder Windungszahlen aufweisen.

7. Messanordnung (1) nach einem der Ansprüche 1 bis 6, **dadurch gekennzeichnet, dass** eine Windungszahl wenigstens einer Messspule (6, 7) der Messspulenanordnung (2) größer als eine Windungszahl wenigstens einer zugehörigen Kompensationsspule (11, 12, 13, 14) der Kompensationsspulenanordnung ist.

8. Messanordnung (1) nach einem der Ansprüche 1 bis 7, **dadurch gekennzeichnet, dass** die Messspulen (6, 7) und die Kompensationsspulen (11, 12, 13, 14) in einer an die erste Erfassungseinrichtung (4) angeschlossenen Masche (28) angeordnet sind und/oder dass die Wicklungsrichtungen der Messspulen (6, 7) und der Kompensationsspulen (11, 12, 13, 14) übereinstimmen.

9. Messanordnung (1) nach einem der Ansprüche 1 bis 8, **dadurch gekennzeichnet, dass** die Messspulen (6, 7) und/oder die Kompensationsspulen (11, 12, 13, 14) als Luftspulen ausgebildet sind und/oder dass die Messspulenanordnung (2) und/oder die Kompensationsspulenanordnung (3) eine oder die vorzugsweise gabelförmige und/oder starre Stromleiteraufnahme (8) für einen zu messenden Stromleiter definieren, insbesondere zwischen einer oder der ersten Messspule (6) der Messspulenanordnung (2) und einer oder der zweiten Messspule (7) der Messspulenanordnung (2).

10. Messanordnung (1) nach einem der Ansprüche 1 bis 9, **dadurch gekennzeichnet, dass** die Messspulenanordnung (2) und/oder die Kompensationsspulenanordnung (3) räumlich spiegelsymmetrisch angeordnet sind und/oder dass die Messspulenanordnung (2) und die Kompensationsspulenanordnung (3) so abgestimmt sind, dass die Summe der magnetischen Flüsse in den Messspulen (6, 7) und den Kompensationsspulen (11, 12, 13, 14) für einen außerhalb einer oder der Stromleiteraufnahme (8) liegenden Stromleiter gleich Null ist.

11. Messanordnung (1) nach einem der Ansprüche 1 bis 10, **dadurch gekennzeichnet, dass** eine Messfehlererkennungseinrichtung (31) zum Vergleich der Signale der ersten Messspule (6) und/oder zweiten Messspule (7) einerseits mit dem gemeinsamen Signal der Messspulenanordnung (2) und der Kompensationsspulenanordnung (3) andererseits eingerichtet ist, insbesondere zur Ausgabe eines Messfehlerhinweises, wenn das gemeinsame Signal kleiner als das Signal der ersten Messspule (6) und/oder der zweiten Messspule (7) ist.

12. Messanordnung (1) nach einem der Ansprüche 1 bis 11, **dadurch gekennzeichnet, dass** eine Aktivierungsvorrichtung (32) zu einer Erfassung eines Signals der Messspulenanordnung (2) und/oder der Kompensationsspulenanordnung (3) und zu einer Aktivierung einer weiteren Komponente zur Verarbeitung und/oder Ausgabe eines Messwerts der Messspulenanordnung (2), wenn das Signals ein hinterlegtes Kriterium erfüllt, eingerichtet ist.

13. Messanordnung (1) nach einem der Ansprüche 1 bis 12, **dadurch gekennzeichnet, dass** eine Messbereichsumschalteinrichtung (33) zu einem Umschalten von einer Verarbeitung des gemeinsamen Signals der Messspulenanordnung (2) und der Kompensationsspulenanordnung (3) zu einer Verarbeitung des Signals der Messspulenanordnung (2) allein, wenn das Signal einen Schwellwert übersteigt, eingerichtet ist.

14. Verfahren zur berührungslosen Stromstärkemessung in einem Stromleiter, wobei in einer Messspulenanordnung (2) ein Signal durch Induktion von dem Stromleiter erzeugt wird und der Messspulenanordnung (2) eine Kompensationsspulenanordnung (3) zugeordnet ist, **dadurch gekennzeichnet, dass** ein gemeinsames Signal der Messspulenanordnung (2) und der Kompensationsspulenanordnung (3) erfasst wird und dass zusätzlich ein Signal wenigstens einer Messspule (6, 7) der Messspulenanordnung (2) erfasst wird.

15. Verfahren nach Anspruch 14, **dadurch gekennzeichnet, dass** ein Messfehlerhinweis, wenn das gemeinsame Signal kleiner als das Signal der wenigstens einen Messspule (6, 7) ist, ausgegeben und/oder von einer Auswertung des gemeinsamen Signals auf eine Auswertung des Signals der wenigstens einen Messspule (6, 7), wenn das Signal einen Schwellwert überschreitet, umgeschaltet wird und/oder dass eine Messanordnung (1) nach einem der Ansprüche 1 bis 13 verwendet wird.

## Claims

1. Measuring arrangement (1) for contactless electric current measurement, comprising a measuring coil arrangement (2), a compensating coil arrangement (3) and a first detection device (4) which is configured to detect a common signal of the measuring coil arrangement (2) and the compensating coil arrangement (3), **characterized by** a second detection device (5) which is configured to additionally detect a signal of at least one measuring coil (6, 7) of the measuring coil arrangement (2).

2. Measuring arrangement (1) according to Claim 1, **characterized in that** the measuring coil arrangement (2) has a first measuring coil (6) and a second measuring coil (7), in particular on both sides and/or on mutually opposite sides (35, 36) of an electric conductor receptacle (8), and/or **in that** one, or each, measuring coil (6, 7) of the measuring coil arrangement (2) has electrically assigned thereto at least one compensating coil (11, 12, 13, 14), preferably two compensating coils (11, 12, 13, 14), of the compensating coil arrangement (3).

3. Measuring arrangement (1) according to Claim 1 or 2, **characterized in that** the compensating coils (11, 12, 13, 14) assigned to a measuring coil (6, 7) are each arranged at one end (15, 16, 17, 18) of the measuring coil (6, 7) and/or aligned at an angle of between 45° and 135°, preferably of between 80° and 100°, particularly preferably of 90°, in relation to the measuring coil (6, 7).

4. Measuring arrangement (1) according to one of Claims 1 to 3, **characterized in that** the first detection device (4) and the second detection device (5) each have an amplification member (19, 20) and/or **in that** a digital signal processing device (19, 20) is connected in each case to the first detection device (4) and the second detection device (5).

5. Measuring arrangement (1) according to one of Claims 1 to 4, **characterized in that** the second detection device (5) is configured to detect a signal of a, or the, first measuring coil (6) of the measuring coil arrangement (2), and a third detection device (23) is configured to detect a signal of a, or the, second measuring coil (7) of the measuring coil arrangement (2) .

6. Measuring arrangement (1) according to one of Claims 1 to 5, **characterized in that** the compensating coils (11, 12, 13, 14) of the compensating coil arrangement (3) have substantially identical cross sections, winding densities and/or number of turns and/or **in that** the measuring coils (6, 7) of the measuring coil arrangement (2) have substantially identical cross sections, winding densities and/or number of turns.

7. Measuring arrangement (1) according to one of Claims 1 to 6, **characterized in that** a number of turns of at least one measuring coil (6, 7) of the measuring coil arrangement (2) is greater than a number of turns of at least one assigned compensating coil (11, 12, 13, 14) of the compensating coil arrangement.

8. Measuring arrangement (1) according to one of Claims 1 to 7, **characterized in that** the measuring coils (6, 7) and the compensating coils (11, 12, 13, 14) are arranged in a mesh (28) connected to the first detection device (4) and/or **in that** the winding directions of the measuring coils (6, 7) and of the compensating coils (11, 12, 13, 14) correspond.

9. Measuring arrangement (1) according to one of Claims 1 to 8, **characterized in that** the measuring coils (6, 7) and/or the compensating coils (11, 12, 13, 14) are embodied as air coils and/or **in that** the measuring coil arrangement (2) and/or the compensating coil arrangement (3) define a, or the, preferably forkshaped and/or rigid electric conductor receptacle (8) for an electric conductor to be measured, in particular between a, or the, first measuring coil (6) of the measuring coil arrangement (2) and a, or the, second measuring coil (7) of the measuring coil arrangement (2).

10. Measuring arrangement (1) according to one of Claims 1 to 9, **characterized in that** the measuring coil arrangement (2) and/or the compensating coil arrangement (3) are arranged in a spatially mirror-symmetric manner and/or **in that** the measuring coil arrangement (2) and the compensating coil arrangement (3) are matched in such a way that the sum of the magnetic flux in the measuring coils (6, 7) and in the compensating coils (11, 12, 13, 14) equals zero for an electric conductor lying outside of an, or the, electric conductor receptacle (8).

11. Measuring arrangement (1) according to one of Claims 1 to 10, **characterized in that** a measuring error recognition device (31) is configured to compare, firstly, the signals from the first measuring coil (6) and/or second measuring coil (7) with, secondly, the common signal of the measuring coil arrangement (2) and the compensating coil arrangement (3), in particular to output a measuring error notification if the common signal is less than the signal from the first measuring coil (6) and/or the second measuring coil (7).

12. Measuring arrangement (1) according to one of Claims 1 to 11, **characterized in that** an activation apparatus (32) is configured to detect a signal of the measuring coil arrangement (2) and/or of the compensating coil arrangement (3) and to activate a further component for processing and/or outputting a measured value of the measuring coil arrangement (2) if the signal satisfies a stored criterion.

13. Measuring arrangement (1) according to one of Claims 1 to 12, **characterized in that** a measuring range switching device (33) is configured to switch from processing the common signal of the measuring coil arrangement (2) and the compensating coil arrangement (3) to only processing the signal from the measuring coil arrangement (2) when the signal exceeds a threshold.

14. Method for contactless electric current measurement in an electric conductor, wherein a signal is generated in a measuring coil arrangement (2) by induction from the electric conductor and the measuring coil arrangement (2) has assigned to it a compensating coil arrangement (3), **characterized in that** a common signal of the measuring coil arrangement (2) and the compensating coil arrangement (3) is detected and **in that** a signal of at least one measuring coil (6, 7) of the measuring coil arrangement (2) is additionally detected.

15. Method according to Claim 14, **characterized in that** a measuring error notification is output if the common signal is less than the signal of the at least one measuring coil (6, 7) and/or a switch is made from an evaluation of the common signal to an evaluation of the signal from the at least one measuring coil (6, 7) if the signal exceeds a threshold, and/or **in that** use is made of a measuring arrangement (1) according to one of Claims 1 to 13.

## Revendications

1. Dispositif de mesure (1) pour la mesure sans contact de l'intensité de courants électriques, avec un agencement de bobines de mesure (2), un agencement de bobines de compensation (3) et un premier dispositif de détection (4), qui est conçu pour détecter un signal commun de l'agencement de bobines de mesure (2) et de l'agencement de bobines de compensation (3), **caractérisé par** un deuxième dispositif de détection (5), qui est conçu pour détecter en outre un signal d'au moins une bobine de mesure (6, 7) de l'agencement de bobines de mesure (2).

2. Dispositif de mesure (1) selon la revendication 1, **caractérisé en ce que** l'agencement de bobines de mesure (2) présente une première bobine de mesure (6) et une seconde bobine de mesure (7), en particulier de part et d'autre et/ou sur deux côtés opposés l'un à l'autre (35, 36) d'un logement de conducteur électrique (8), et/ou **en ce qu'**à une ou à chaque bobine de mesure (6, 7) de l'agencement de bobines de mesure (2) est/sont électriquement associée(s) au moins une bobine de compensation (11, 12, 13, 14), de préférence deux bobines de compensation (11, 12, 13, 14) de l'agencement de bobines de compensation (3).

3. Dispositif de mesure (1) selon une revendication 1 ou 2, **caractérisé en ce que** les bobines de compensation (11, 12, 13, 14) associées à une bobine de mesure (6, 7) sont disposées chacune à une extrémité (15, 16, 17, 18) de la bobine de mesure (6, 7) et/ou sont orientées sous un angle compris entre 45° et 135°, de préférence entre 80° et 100°, de préférence encore de 90°, par rapport à la bobine de mesure (6, 7).

4. Dispositif de mesure (1) selon l'une quelconque des revendications 1 à 3, **caractérisé en ce que** le premier dispositif de détection (4) et le deuxième dispositif de détection (5) présentent respectivement un organe d'amplification (19, 20) et/ou **en ce qu'**au premier dispositif de détection (4) et au deuxième dispositif de détection est respectivement raccordé un dispositif de traitement de signaux numériques (19, 20).

5. Dispositif de mesure (1) selon l'une quelconque des revendications 1 à 4, **caractérisé en ce que** le deuxième dispositif de détection (5) est conçu pour détecter un signal d'une ou de la première bobine de mesure (6) de l'agencement de bobines de mesure (2), et un troisième dispositif de détection (23) est conçu pour détecter un signal d'une ou de la seconde bobine de mesure (7) de l'agencement de bobines de mesure (2).

6. Dispositif de mesure (1) selon l'une quelconque des revendications 1 à 5, **caractérisé en ce que** les bobines de compensation (11, 12, 13, 14) de l'agencement de bobines de compensation (3) présentent des sections transversales, des densités d'enroulement et/ou des nombres de spires essentiellement identiques et/ou **en ce que** les bobines de mesure (6, 7) de l'agencement de bobines de mesure (2) présentent des sections transversales, des densités d'enroulement et/ou des nombres de spires essentiellement identiques.

7. Dispositif de mesure (1) selon l'une quelconque des revendications 1 à 6, **caractérisé en ce qu'**un nombre de spires d'au moins une bobine de mesure (6, 7) de l'agencement de bobines de mesure (2) est plus grand qu'un nombre de spires d'au moins une bobine de compensation correspondante (11, 12, 13, 14) de l'agencement de bobines de compensation.

8. Dispositif de mesure (1) selon l'une quelconque des revendications 1 à 7, **caractérisé en ce que** les bobines de mesure (6, 7) et les bobines de compensation (11, 12, 13, 14) sont disposées dans une maille (28) raccordée au premier dispositif de détection (4) et/ou **en ce que** les directions d'enroulement des bobines de mesure (6, 7) et des bobines de compensation (11, 12, 13, 14) coïncident.

9. Dispositif de mesure (1) selon l'une quelconque des revendications 1 à 8, **caractérisé en ce que** les bobines de mesure (6, 7) et/ou les bobines de compensation (11, 12, 13, 14) sont réalisées sous la forme de bobines à air et/ou **en ce que** l'agencement de bobines de mesure (2) et/ou l'agencement de bobines de compensation (3) définissent un ou le logement de conducteur électrique (8) en forme de fourche et/ou rigide pour un conducteur de courant à mesurer, en particulier entre une ou la première bobine de mesure (6) de l'agencement de bobines de mesure (2) et une ou la seconde bobine de mesure (7) de l'agencement de bobines de mesure (2).

10. Dispositif de mesure (1) selon l'une quelconque des revendications 1 à 9, **caractérisé en ce que** l'agencement de bobines de mesure (2) et/ou l'agencement de bobines de compensation (3) sont disposés de façon symétrique réfléchie dans l'espace et/ou **en ce que** l'agencement de bobines de mesure (2) et l'agencement de bobines de compensation (3) sont accordés de telle manière que la somme des flux magnétiques dans les bobines de mesure (6, 7) et les bobines de compensation (11, 12, 13, 14) soit égale à zéro pour un conducteur électrique situé à l'extérieur d'un ou du logement de conducteur électrique (8).

11. Dispositif de mesure (1) selon l'une quelconque des revendications 1 à 10, **caractérisé en ce qu'**un dispositif de détection d'erreurs de mesure (31) est conçu pour la comparaison des signaux de la première bobine de mesure (6) et/ou de la seconde bobine de mesure (7) d'une part avec le signal commun de l'agencement de bobines de mesure (2) et de l'agencement de bobines de compensation (3) d'autre part, en particulier pour l'émission d'un message d'erreur de mesure, lorsque le signal commun est inférieur au signal de la première bobine de mesure (6) et/ou de la seconde bobine de mesure (7).

12. Dispositif de mesure (1) selon l'une quelconque des revendications 1 à 11, **caractérisé en ce qu'**un dispositif d'activation (32) est conçu pour une détection d'un signal de l'agencement de bobines de mesure (2) et/ou de l'agencement de bobines de compensation (3) et pour une activation d'un autre composant pour le traitement et/ou l'émission d'une valeur de mesure de l'agencement de bobines de mesure (2) lorsque le signal satisfait un critère mémorisé.

13. Dispositif de mesure (1) selon l'une quelconque des revendications 1 à 12, **caractérisé en ce qu'**un dispositif de commutation de domaine de mesure (33) est conçu pour une commutation d'un traitement du signal commun de l'agencement de bobines de mesure (2) et de l'agencement de bobines de compensation (3) à un traitement du signal de l'agencement de bobines de mesure (2) seul, lorsque le signal dépasse une valeur de seuil.

14. Procédé pour la mesure sans contact de l'intensité de courants électriques dans un conducteur électrique, dans lequel on produit un signal par induction à partir d'un conducteur électrique dans un agencement de bobines de mesure (2) et on associe un agencement de bobines de compensation (3) à l'agencement de bobines de mesure (2), **caractérisé en ce que** l'on détecte un signal commun de l'agencement de bobines de mesure (2) et de l'agencement de bobines de compensation (3) et **en ce que** l'on détecte en outre un signal d'au moins une bobine de mesure (6, 7) de l'agencement de bobines de mesure (2).

15. Procédé selon la revendication 14, **caractérisé en ce que** l'om émet un message d'erreur de mesure, lorsque le signal commun est inférieur au signal de ladite au moins une bobine de mesure (6, 7) et/ou **en ce que** l'on commute d'une évaluation du signal commun à une évaluation du signal de ladite au moins une bobine de mesure (6, 7), lorsque le signal dépasse une valeur de seuil, et/ou **en ce que** l'on utilise un dispositif de mesure (1) selon l'une quelconque des revendications 1 à 13.
